(19) Europäisches Patentamt / European Patent Office / Office européen des brevets

(11) **EP 4 782 888 A1**

(12) **EUROPEAN PATENT APPLICATION**
published in accordance with Art. 153(4) EPC

(43) Date of publication:
**29.07.2026 Bulletin 2026/31**

(21) Application number: **24909209.9**

(22) Date of filing: **07.11.2024**

(51) International Patent Classification (IPC):
*G01W 1/10* (2006.01)  *G01W 1/18* (2006.01)
*G06F 30/20* (2020.01)  *G06Q 50/26* (2024.01)

(52) Cooperative Patent Classification (CPC):
**G01W 1/10; G01W 1/18; G06F 17/17; G06F 30/20; G06Q 50/26**

(86) International application number:
**PCT/KR2024/017529**

(87) International publication number:
**WO 2026/100766 (15.05.2026 Gazette 2026/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **05.11.2024 KR 20240155231**

(71) Applicant: **Weatheri Inc.**
**Seoul 07238 (KR)**

(72) Inventor: **KIM, Young Doh**
**Seoul 05236 (KR)**

(74) Representative: **Manitz Finsterwald**
**Patent- und Rechtsanwaltspartnerschaft mbB**
**Martin-Greif-Straße 1**
**80336 München (DE)**

(54) **SERVER, METHOD, AND COMPUTER PROGRAM FOR EXPANDING SPATIO-TEMPORAL RESOLUTION OF WEATHER DATA AND PROVIDING SAME TO TERMINAL**

(57)    A server for providing weather data to a device with enhanced spatio-temporal resolution includes: a receiver configured to receive weather data from a weather model, the data having a predetermined spatial and temporal resolution; a converter configured to convert the received weather data into matrix data including forecast values for each latitude and longitude; an enhancer configured to subdivide the latitude and longitude of the matrix data into finer intervals than the predetermined spatial resolution and to enhance the spatial resolution by interpolating forecast values at the subdivided latitude and longitude positions; and a transmitter configured to transmit the weather data with the enhanced spatial resolution to the device.

*FIG. 1*

DEVICE — 100 — WEATHER MODEL 단말

EP 4 782 888 A1

**Description**

**TECHNICAL FIELD**

The present disclosure relates to a server, method, and computer program for receiving weather data from a weather model and providing the data to a device with enhanced spatio-temporal resolution.

**BACKGROUND**

Weather forecasting is conducted through global weather models, such as GFS and ECMWF, which provide weather data over large geographic areas. These weather models are primarily used to monitor atmospheric conditions and predict future weather, and the collected data is applied across various industries, including agriculture, energy management, aviation, and maritime transport.

In particular, the spatio-temporal resolution of weather data is a critical factor that significantly affects real-time climate monitoring and forecasting accuracy. As the effects of weather change intensify, the importance of high-resolution data continues to grow.

However, the spatio-temporal resolution currently provided by global weather models is designed for broad regional scales. Due to the inherent characteristics of these models, resolution is often limited to reduce computational load, which makes it difficult to obtain detailed weather information for specific or small regions. Therefore, in various industries that utilize weather data, the spatio-temporal resolution provided by existing models is insufficient, leading to a demand for enhanced resolution.

**PRIOR ART DOCUMENT**

(Patent Document) Korean Patent No. 2063358 (registered on December 31, 2019)

**DISCLOSURE OF THE INVENTION**

**PROBLEMS TO BE SOLVED BY THE INVENTION**

The present disclosure has been made in an effort to solve the problems of the prior art, and is conceived to enhance spatial resolution of weather data.

The present disclosure is conceived to enhance temporal resolution of weather data.

However, the problems to be solved by the present disclosure are not limited to the above-described problems. There may be other problems to be solved by the present disclosure.

**MEANS FOR SOLVING THE PROBLEMS**

As a means for achieving the above-described technical problems, a first aspect of the present disclosure provides a server for providing weather data to a device with enhanced spatio-temporal resolution, including: a receiver configured to receive weather data from a weather model, the data having a predetermined spatial and temporal resolution; a converter configured to convert the received weather data into matrix data including forecast values for each latitude and longitude; an enhancer configured to subdivide the latitude and longitude of the matrix data into finer intervals than the predetermined spatial resolution and to enhance the spatial resolution by interpolating forecast values at the subdivided latitude and longitude positions; and a transmitter configured to transmit the weather data with the enhanced spatial resolution to the device.

A second aspect of the present disclosure provides a method for providing weather data to a device with enhanced spatio-temporal resolution, including: a process of receiving weather data from a weather model, the data having a predetermined spatial and temporal resolution; a process of converting the received weather data into matrix data including forecast values for each latitude and longitude; a process of subdividing the latitude and longitude of the matrix data into finer intervals than the predetermined spatial resolution and enhancing the spatial resolution by interpolating forecast values at the subdivided latitude and longitude positions; and a process of transmitting the weather data with the enhanced spatial resolution to the device.

A third aspect of the present disclosure provides a computer program including a sequence of instructions, which, when executed by a computing device, causes the computing device to: receive weather data from a weather model, the data having a predetermined spatial and temporal resolution; convert the received weather data into matrix data including forecast values for each latitude and longitude; subdivide the latitude and longitude of the matrix data into finer intervals than the predetermined spatial resolution and enhance the spatial resolution by interpolating forecast values at the subdivided latitude and longitude positions; and transmit the weather data with the enhanced spatial resolution to the device.

The above-described aspects are provided by way of illustration only and should not be construed as liming the present disclosure. Besides the above-described embodiments, there may be additional embodiments described in the accompanying drawings and the detailed description.

## EFFECTS OF THE INVENTION

According to any one of the above-described means for solving the problems of the present disclosure, it is possible to convert weather data received from a server into matrix data including forecast values for each latitude and longitude, subdivide the latitude and longitude of the matrix data into finer intervals than a predetermined spatial resolution, and enhance the spatial resolution of the weather data by interpolating forecast values at the subdivided latitude and longitude positions.

Also, it is possible to subdivide a forecast time interval of weather data into finer intervals than a predetermined temporal resolution and enhance the temporal resolution by interpolating forecast values for the subdivided forecast time intervals.

## BRIEF DESCRIPTION OF THE DRAWINGS

FIG. 1 is a configuration view of a server for providing weather data to a device with enhanced spatio-temporal resolution according to an embodiment of the present disclosure.

FIG. 2 is a block diagram of the server of **FIG. 1** according to an embodiment of the present disclosure.

FIG. 3 is an exemplary diagram illustrating a method for providing weather data to a device with enhanced spatio-temporal resolution by a server according to an embodiment of the present disclosure.

FIG. 4A to FIG. 4D are exemplary diagrams illustrating a method for providing weather data to a device with enhanced spatio-temporal resolution by a server according to an embodiment of the present disclosure.

FIG. 5 is a flowchart showing a method for providing weather data to a device with enhanced spatio-temporal resolution according to an embodiment of the present disclosure.

## BEST MODE FOR CARRYING OUT THE INVENTION

Hereafter, example embodiments will be described in detail with reference to the accompanying drawings so that the present disclosure may be readily implemented by those skilled in the art. However, it is to be noted that the present disclosure is not limited to the example embodiments but can be embodied in various other ways. In the drawings, parts irrelevant to the description are omitted for the simplicity of explanation, and like reference numerals denote like parts through the whole document.

Throughout this document, the term "connected to" may be used to designate a connection or coupling of one element to another element and includes both an element being "directly connected" another element and an element being "electronically connected" to another element via another element. Further, it is to be understood that the terms "comprises," "includes," "comprising," and/or "including" means that one or more other components, steps, operations, and/or elements are not excluded from the described and recited systems, devices, apparatuses, and methods unless context dictates otherwise; and is not intended to preclude the possibility that one or more other components, steps, operations, parts, or combinations thereof may exist or may be added.

Throughout this document, the term "unit" may refer to a unit implemented by hardware, software, and/or a combination thereof. As examples only, one unit may be implemented by two or more pieces of hardware or two or more units may be implemented by one piece of hardware.

Throughout this document, a part of an operation or function described as being carried out by a terminal or device may be implemented or executed by a device connected to the terminal or device. Likewise, a part of an operation or function described as being implemented or executed by a device may be so implemented or executed by a terminal or device connected to the device.

Hereinafter, embodiments of the present disclosure will be described in detail with reference to the accompanying drawings.

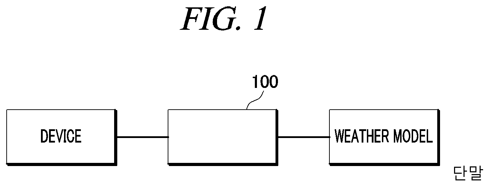

FIG. 1 is a configuration view of a server for providing weather data to a device with enhanced spatio-temporal resolution according to an embodiment of the present disclosure. Referring to **FIG. 1**, a system for providing weather data to a device with enhanced spatio-temporal resolution may include a server 100, the device, and a weather model. Herein, the device may include a plurality of devices.

However, the system for providing weather data to the device with enhanced spatio-temporal resolution illustrated in **FIG. 1** is just an embodiment of the present disclosure and should not be construed as liming the present disclosure and can be configured differently from that shown in **FIG. 1** according to various embodiments of the present disclosure.

The components of the system for providing weather data to the device with enhanced spatio-temporal resolution illustrated in **FIG. 1** are typically connected to each other via a network. The network refers to a connection structure that enables information exchange between nodes such as devices, servers, etc. and includes LAN (Local Area Network), WAN (Wide Area Network), Internet (WWW: World Wide Web), a wired or wireless data communication network, a telecommunication network, a wired or wireless television network, and the like. Examples of the wireless data communication network may include 3G, 4G, 5G, 3GPP (3rd Generation Partnership Project), LTE (Long Term Evolution), WIMAX (World Interoperability for Microwave Access), Wi-Fi, Bluetooth communication, infrared communication, ultrasonic communication, VLC (Visible Light Communication), LiFi, and the like, but may not be limited thereto.

The server 100 may enhance weather data of a weather model and provide the data to the device. The server 100 may receive the weather data having a predetermined spatial and temporal resolution from the weather model.

The weather model refers to a numerical model that simplifies complex interactions between climate elements into physical and dynamical numerical equations in order to simulate the components of the climate system, such as the atmosphere, ocean, and land surface. As a result of simulation, weather data can be generated.

According to the present disclosure, the weather model may be any one of GFS (Global Forecast System), ECMWF (The European Centre for Medium Range Weather Forecasts), KWRF (Korea Weather Research and Forecasting model), JGSM (Japan Global Spectral Model), and NOGAPS (Navy Operational Global Atmospheric Prediction System, but is not limited thereto.

The server 100 may convert the weather data received from the weather model into matrix data 121a including forecast values for each latitude and longitude.

For example, the server 100 may convert the weather data received from the weather model into the matrix data 121a. The matrix data 121a includes forecast values by longitude referenced on the vertical axis, and forecast values by latitude referenced on the horizontal axis.

The server 100 may convert the received weather data into the matrix data 121a for each predetermined forecast time interval, and thus generate a plurality of pieces of matrix data 121 corresponding to different forecast times.

For example, the server 100 may generate the plurality of pieces of matrix data 121 corresponding to different forecast times by using the time axis perpendicular to the longitude and latitude axes.

The weather data may be information derived by simulating interactions between climate elements.

For example, the weather data may include spatial resolution and temporal resolution. Specifically, the weather data may include at least one of latitude range, longitude range, latitude-longitude interval, number of longitude coordinates, number of latitude coordinates, forecast time, time interval, reception cycle, and forecast values.

The spatial resolution may be an indicator of how precisely the weather model can represent forecasted weather data for a specific region through simulation.

It may correspond to the minimum unit of the land surface.

The temporal resolution may be an indicator of how frequently image data for a specific region is obtained through simulation by the weather model.

The latitude range and longitude range may represent the total area covered by the weather model's simulation and prediction.

The latitude-longitude interval may refer to the angular distance between adjacent lines of latitude and adjacent lines of longitude.

The number of longitude coordinates may refer to the total number of longitude points within the simulated area of the weather model.

The number of latitude coordinates may refer to the total number of latitude points within the simulated area of the weather model.

The forecast time may refer to the total duration of the temporal resolution predicted by the weather model through simulation.

The time interval may refer to the interval of the temporal resolution predicted by the weather model through simulation.

The reception cycle may refer to the cycle at which the weather data generated by the weather model through simulation is forecasted.

The forecast values may refer to weather information between longitude coordinates and latitude coordinates predicted by the weather model through simulation.

For example, the weather data from the weather models, such as GFS (Global Forecast System) and ECMWF (The European Centre for Medium Range Weather Forecasts), can be represented as shown in Table 1 and Table 2.

[Table 1]

| 1 | File format | GRIB2 |
|---|---|---|
| 2 | Latitude range | -90 to 90 |
| 3 | Longitude range | -180 to 180 |
| 4 | Latitude-longitude interval | 0.5 degrees |
| 5 | Number of longitude coordinates | 720 |
| 6 | Number of latitude coordinates | 361 |
| 7 | Forecast time | 0 h to 384 h |
| 8 | Time interval | 3 hours |
| 9 | Reception cycle | 4 times/day (00, 06, 12, 18 UTC) |

Table 1 shows the weather data that can be received from GFS. Herein, GRIB2 (GRIdded Binary) refers to a program file format used in meteorological, atmospheric, and oceanographic fields to store historical and forecast weather data.

UTC refers to Coordinated Universal Time, which is used as the reference time for international standard time.

[Table 2]

| 1 | File format | GRIB2 |
|---|---|---|
| 2 | Latitude range | -90 to 90 |
| 3 | Longitude range | -180 to 180 |
| 4 | Latitude-longitude interval | 0.4 degrees |
| 5 | Number of longitude coordinates | 900 |
| 6 | Number of latitude coordinates | 451 |
| 7 | Forecast time | 0 h to 240 h |
| 8 | Time interval | 3 hours |
| 9 | Reception cycle | Twice/day (00, 12 UTC) |

Table 2 shows the weather data that can be received from ECMWF. Referring to the number of longitude and latitude coordinates and the latitude-longitude intervals of ECMWF weather data, it can be seen that the spatial resolution is finer and higher than that of GFS (Global Forecast System).

The server 100 may subdivide the latitude and longitude of the converted matrix data 121a into finer intervals than the predetermined spatial resolution and enhance the spatial resolution by interpolating forecast values at the subdivided latitude and longitude positions.

For example, the server 100 may subdivide the intervals between adjacent lines of latitude and adjacent lines of longitude in the converted matrix data 121a into narrower intervals than the predetermined intervals, and enhance the spatial resolution by interpolating forecast values at the subdivided latitude and longitude positions.

The server 100 may subdivide a forecast time interval of the weather data into finer intervals than the predetermined temporal resolution and enhance the temporal resolution by interpolating forecast values for the subdivided forecast time intervals.

The server 100 may transmit the weather data with the enhanced spatial resolution to the device.

Hereinafter, operations of the components of the system for providing weather data to a device with enhanced spatio-temporal resolution illustrated in **FIG. 1** will be described in more detail.

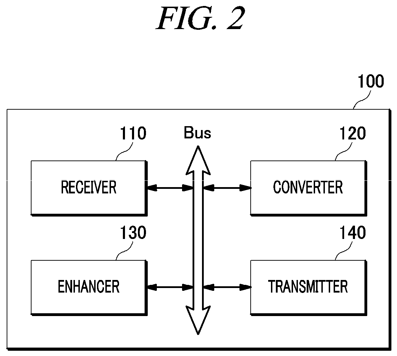

**FIG. 2** is a block diagram of the server 100 of **FIG. 1** according to an embodiment of the present disclosure.

Referring to **FIG. 2**, the server 100 may include a receiver 110, a converter 120, an enhancer 130, and a transmitter 140. However, the server 100 illustrated in **FIG. 2** is merely an embodiment of the present disclosure, and various modifications based on the components illustrated in **FIG. 2** are possible.

The receiver 110 may receive weather data having a predetermined spatial and temporal resolution from a weather model.

The converter 120 may convert the weather data received by receiver 110 into the matrix data 121a including forecast values for each latitude and longitude.

The matrix data 121a may include longitude along the horizontal axis and latitude along the vertical axis, using longitude and latitude as coordinates. The matrix data 121a may also include a forecast value for each of longitude-latitude coordinate pairs.

The matrix data 121a may include longitude along the horizontal axis and time along the vertical axis, using longitude and time as coordinates. The matrix data 121a may also include a forecast value for each of longitude-time coordinate pairs.

The matrix data 121a may include latitude along the horizontal axis and time along the vertical axis, using latitude and time as coordinates. The matrix data 121a may also include a forecast value for each of latitude-time coordinate pairs.

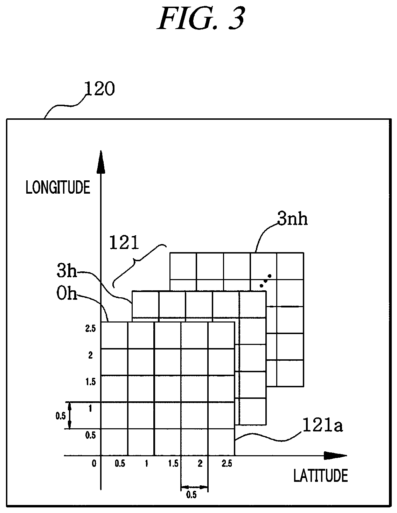

For example, referring to **FIG. 3**, the converter 120 may convert the weather data received by the receiver 110 into a format where the longitude is represented along the vertical axis at 0.5 intervals, and the latitude is represented along the horizontal axis at 0.5 intervals. The upper-right region corresponding to a specific longitude and latitude may be a forecast value.

For example, when the longitude is 0.5 and the latitude is 0, the forecast value may be p1.

The converter 120 may convert the received weather data into the matrix data 121a for each predetermined forecast time interval, and thus generate the plurality of pieces of matrix data 121 corresponding to different forecast times.

Also, for example, referring to **FIG. 3**, when the predetermined forecast time interval is 3 hours, the converter 120 may convert the matrix data 121a including forecast values for each latitude and longitude into the plurality of pieces of matrix data 121 for every 3-hour interval by using the time axis perpendicular to the longitude and latitude axes, based on the weather data received by the receiver 110.

Referring back to **FIG. 2**, the enhancer 130 may subdivide the latitude and longitude of the matrix data 121a converted by the converter 120 into finer intervals than the predetermined spatial resolution and enhance the spatial resolution by interpolating forecast values at the subdivided latitude and longitude positions.

The enhancer 130 may subdivide the latitude into finer intervals than the predetermined spatial resolution and enhance the spatial resolution by interpolating forecast values at the subdivided longitude and latitude positions by bilinear interpolation.

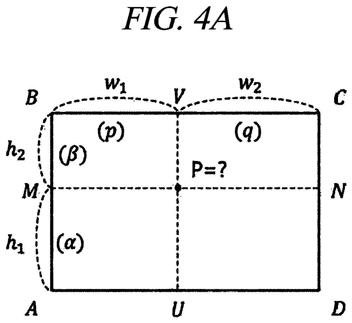

For example, referring to **FIG. 4A**, the enhancer 130 may subdivide the longitude and latitude of the matrix data 121a converted by the converter 120 into finer intervals than the predetermined spatial resolution and derive forecast values at the subdivided longitude and latitude positions as shown in Equation 1 below.

[Equation 1]

$$P = q(\beta A + \alpha B) + p(\beta D + \alpha C) = q\beta A + q\alpha B + p\beta D + p\alpha C$$

Herein, when the horizontal distances from point P to the edges of the rectangle are denoted as $W_1$ and $W_2$, the vertical distances are denoted as $h_1$ and $h_2$, and the data values at the four points are denoted as A, B, C, and D, respectively, the data value at point P can be calculated by bilinear interpolation, as shown in Equation 1 below. Herein, $\alpha=h_1/(h_1+h_2)$, $\beta=h_2/(h_1+h_2)$, $p=W_1/(W_1+W_2)$, $q=W_2/(W_1+W_2)$).

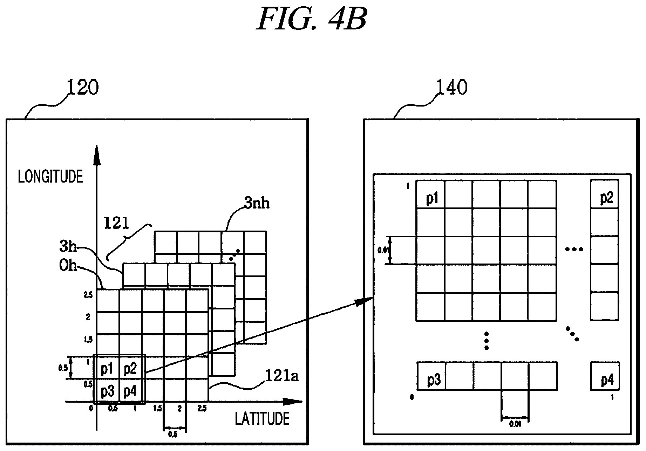

Referring to **FIG. 4B**, the matrix data 121a includes latitude along the horizontal axis and longitude along the vertical axis. The forecast values p1, p2, p3 and p4 defined at coordinates with an interval of 0.5 up to the coordinate (1.1) may be enhanced into the matrix data 121a with an interval of 0.01 between latitudes and longitudes by applying bilinear interpolation.

When the values at A, B, C and D are defined as p1, p2, p3 and p4, respectively, in Equation 1, the forecast value for each of subdivided longitude-latitude coordinate pairs between the coordinate points of p1,p2,p3 and p4 can be interpolated by applying the corresponding distances to Equation 1.

The enhancer 130 may subdivide a forecast time interval of the weather data into finer intervals than the predetermined temporal resolution and enhance the temporal resolution by interpolating forecast values for the subdivided forecast time intervals.

The enhancer 130 may interpolate the forecast values at the subdivided forecast time intervals to increase the number of matrix data 121.

The enhancer 130 may subdivide the latitude into finer intervals than the predetermined temporal resolution and enhance the temporal resolution by interpolating forecast values at the subdivided longitude and latitude positions by bilinear interpolation.

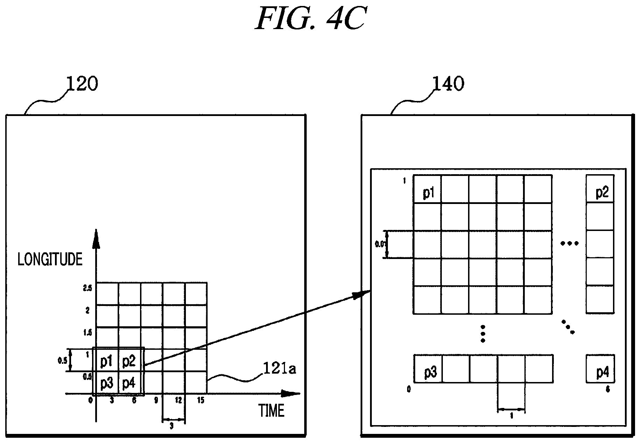

For example, referring to **FIG. 4C**, if the horizontal axis is time and the vertical axis is longitude, the forecast values p1, p2, p3 and p4 defined at coordinates with a longitude interval of 0.5 and a time interval of 3 up to the coordinate (1.6) may be enhanced into the matrix data 121a with a longitude interval of 0.5 and a time interval of 0.01 by applying Equation 1 for bilinear interpolation.

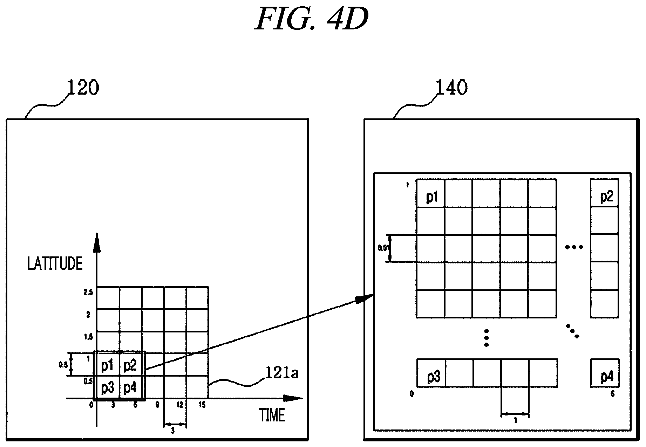

For example, referring to **FIG. 4D**, if the horizontal axis is time and the vertical axis is latitude, the forecast values p1, p2, p3 and p4 defined at coordinates with a longitude interval of 0.5 and a time interval of 3 up to the coordinate (1.6) may be enhanced into the matrix data 121a with a latitude interval of 0.5 and a time interval of 0.01 by applying Equation 1 for bilinear interpolation.

Referring back to **FIG. 2**, the transmitter 140 may transmit the weather data with the enhanced spatial resolution to the device.

The transmitter 140 may further transmit the weather data with the enhanced temporal resolution to the device.

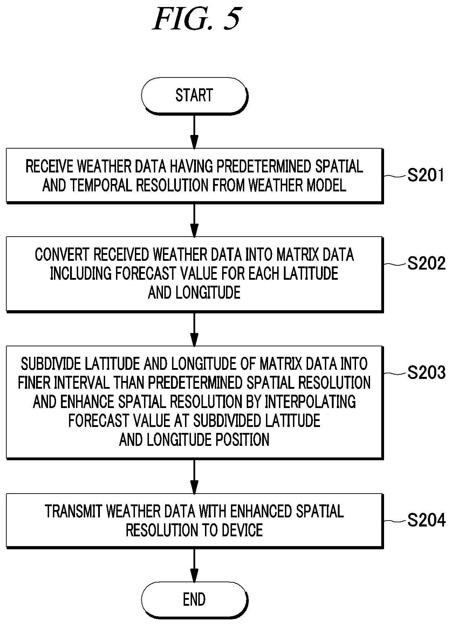

**FIG. 5** is a flowchart showing a method for providing weather data to a device with enhanced spatio-temporal resolution by the server 100 according to an embodiment of the present disclosure.

Referring to **FIG. 5**, in a process S201, the server 100 may receive weather data from a weather model, the data having a predetermined spatial and temporal resolution.

In a process S202, the server 100 may convert the received weather data into the matrix data 121a including forecast values for each latitude and longitude.

In a process S203, the server 100 may subdivide the latitude and longitude of the matrix data 121a into finer intervals than the predetermined spatial resolution and enhance the spatial resolution by interpolating forecast values at the subdivided latitude and longitude positions.

In a process S204, the server 100 may transmit the weather data with the enhanced spatial resolution to the device.

In the descriptions above, the processes S201 to S204 may be divided into additional processes or combined into fewer processes depending on an embodiment. In addition, some of the processes may be omitted and the sequence of the processes may be changed if necessary.

The method for providing weather data to a device with enhanced spatio-temporal resolution illustrated in **FIG. 1** to **FIG. 5** can be implemented as a computer program stored in a medium to be executed by a computer or a recording medium including instructions executable by a computer. Also, the method for providing weather data to a device with enhanced spatio-temporal resolution illustrated in **FIG. 1** to **FIG. 5** can be implemented as a computer program stored in a medium to be executed by a computer.

A computer-readable medium can be any usable medium which can be accessed by the computer and includes all volatile/non-volatile and removable/non-removable media. Further, the computer-readable medium may include all computer storage and communication media. The computer storage medium includes all volatile/non-volatile and removable/non-removable media embodied by a certain method or technology for storing information such as computer-readable instruction code, a data structure, a program module or other data. The communication medium typically includes the computer-readable instruction code, the data structure, the program module, or other data of a modulated data signal such as a carrier wave, or other transmission mechanism, and includes a certain information transmission medium.

The above description of the present disclosure is provided for the purpose of illustration, and it would be understood by those skilled in the art that various changes and modifications may be made without changing technical conception and essential features of the present disclosure. Thus, it is clear that the above-described embodiments are illustrative in all aspects and do not limit the present disclosure. For example, each component described to be of a single type can be implemented in a distributed manner. Likewise, components described to be distributed can be implemented in a combined manner.

The scope of the present disclosure is defined by the following claims rather than by the detailed description of the embodiment. It shall be understood that all modifications and embodiments conceived from the meaning and scope of the claims and their equivalents are included in the scope of the present disclosure.

**Claims**

1. A server for providing weather data to a device with enhanced spatio-temporal resolution, comprising:

   a receiver configured to receive weather data from a weather model, the data having a predetermined spatial and temporal resolution;
   a converter configured to convert the received weather data into matrix data including forecast values for each latitude and longitude;
   an enhancer configured to subdivide the latitude and longitude of the matrix data into finer intervals than the predetermined spatial resolution and to enhance the spatial resolution by interpolating forecast values at the subdivided latitude and longitude positions; and

a transmitter configured to transmit the weather data with the enhanced spatial resolution to the device.

**2.** The server of Claim 1,
wherein the converter converts the received weather data into the matrix data for each predetermined forecast time interval, and thus generates a plurality of pieces of matrix data corresponding to different forecast times.

**3.** The server of Claim 2,

wherein the enhancer subdivides a forecast time interval of the weather data into finer intervals than the predetermined temporal resolution and enhances the temporal resolution by interpolating forecast values for the subdivided forecast time intervals, and
the transmitter further transmits the weather data with the enhanced temporal resolution to the device.

**4.** The server of Claim 3,
wherein the enhancer interpolates the forecast values at the subdivided forecast time intervals to increase the number of matrix data.

**5.** The server of Claim 1,
wherein the matrix data uses longitude and latitude as coordinates, and includes a forecast value for each of longitude-latitude coordinate pairs.

**6.** The server of Claim 5,
wherein the enhancer enhances the spatial resolution by interpolating the forecast value for each coordinate pair by bilinear interpolation.

**7.** A method for providing weather data to a device with enhanced spatio-temporal resolution, comprising:

a process of receiving weather data from a weather model, the data having a predetermined spatial and temporal resolution;
a process of converting the received weather data into matrix data including forecast values for each latitude and longitude;
a process of subdividing the latitude and longitude of the matrix data into finer intervals than the predetermined spatial resolution and enhancing the spatial resolution by interpolating forecast values at the subdivided latitude and longitude positions; and
a process of transmitting the weather data with the enhanced spatial resolution to the device.

**8.** The method of Claim 7,

wherein in the process of converting the received weather data into matrix data,
the received weather data is converted into the matrix data for each predetermined forecast time interval, and thus a plurality of pieces of matrix data corresponding to different forecast times is generated.

**9.** The method of Claim 8,

wherein in the process of enhancing the spatial resolution, a forecast time interval of the weather data is subdivided into finer intervals than the predetermined temporal resolution and the temporal resolution is enhanced by interpolating forecast values for the subdivided forecast time intervals, and
in the process of transmitting the weather data to the device, the weather data with the enhanced temporal resolution is further transmitted to the device.

**10.** The method of Claim 9,

wherein in the process of enhancing the spatial resolution,
the forecast values are interpolated at the subdivided forecast time intervals to increase the number of matrix data.

**11.** The method of Claim 7,
wherein the matrix data uses longitude and latitude as coordinates, and includes a forecast value for each of longitude-latitude coordinate pairs.

12. The method of Claim 11,
wherein the spatial resolution is enhanced by interpolating the forecast value for each coordinate pair by bilinear interpolation.

13. A computer program stored in a computer-readable medium including a sequence of instructions for providing weather data to a device with enhanced spatio-temporal resolution, which, when executed by a computing server, causes the computing server to:

receive weather data from a weather model, the data having a predetermined spatial and temporal resolution;
convert the received weather data into matrix data including forecast values for each latitude and longitude;
subdivide the latitude and longitude of the matrix data into finer intervals than the predetermined spatial resolution and enhance the spatial resolution by interpolating forecast values at the subdivided latitude and longitude positions; and
transmit the weather data with the enhanced spatial resolution to the device.

*FIG. 1*

100

| DEVICE | | | | WEATHER MODEL |

단말

*FIG. 2*

100

110    Bus    120

RECEIVER    CONVERTER

130    140

ENHANCER    TRANSMITTER

## FIG. 3

# FIG. 4A

## FIG. 4B

EP 4 782 888 A1

# FIG. 4C

# FIG. 4D

EP 4 782 888 A1

# FIG. 5

```
                    ┌─────────────┐
                    │    START    │
                    └─────────────┘
                           │
                           ▼
    ┌──────────────────────────────────────────────┐
    │ RECEIVE WEATHER DATA HAVING PREDETERMINED      │      S201
    │ SPATIAL AND TEMPORAL RESOLUTION FROM WEATHER   │
    │ MODEL                                          │
    └──────────────────────────────────────────────┘
                           │
                           ▼
    ┌──────────────────────────────────────────────┐
    │ CONVERT RECEIVED WEATHER DATA INTO MATRIX DATA │      S202
    │ INCLUDING FORECAST VALUE FOR EACH LATITUDE     │
    │ AND LONGITUDE                                  │
    └──────────────────────────────────────────────┘
                           │
                           ▼
    ┌──────────────────────────────────────────────┐
    │ SUBDIVIDE LATITUDE AND LONGITUDE OF MATRIX     │      S203
    │ DATA INTO FINER INTERVAL THAN PREDETERMINED    │
    │ SPATIAL RESOLUTION AND ENHANCE SPATIAL         │
    │ RESOLUTION BY INTERPOLATING FORECAST VALUE AT  │
    │ SUBDIVIDED LATITUDE AND LONGITUDE POSITION     │
    └──────────────────────────────────────────────┘
                           │
                           ▼
    ┌──────────────────────────────────────────────┐
    │ TRANSMIT WEATHER DATA WITH ENHANCED SPATIAL    │      S204
    │ RESOLUTION TO DEVICE                           │
    └──────────────────────────────────────────────┘
                           │
                           ▼
                    ┌─────────────┐
                    │     END     │
                    └─────────────┘
```

## INTERNATIONAL SEARCH REPORT

| International application No. |
|---|
| **PCT/KR2024/017529** |

| A. | CLASSIFICATION OF SUBJECT MATTER |
|---|---|

**G01W 1/10**(2006.01)i; **G01W 1/18**(2006.01)i; **G06F 30/20**(2020.01)i; **G06Q 50/26**(2012.01)i

According to International Patent Classification (IPC) or to both national classification and IPC

| B. | FIELDS SEARCHED |
|---|---|

Minimum documentation searched (classification system followed by classification symbols)

G01W 1/10(2006.01); G06F 16/2458(2019.01); G06F 16/587(2019.01); G06N 20/00(2019.01); G06Q 50/40(2024.01); G08G 1/0967(2006.01); H04W 4/02(2009.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 기상(weather), 위도(latitude), 경도(longitude), 이중선형 보간법(Bilinear Interpolation), 모바일 장치(mobile device)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | CN 112148774 A (HUANENG RENEWABLES CORPORATION LIMITED et al.) 29 December 2020 (2020-12-29)<br>paragraph [0028], claims 1, 4, 6, 7, 9 and figures 1-3 | 1-13 |
| Y | US 2018-0025638 A1 (TOMTOM TRAFFIC B.V.) 25 January 2018 (2018-01-25)<br>paragraphs [0022], [0132]-[0134], [0183]-[0189], [0222]-[0229], claim 55 and figures 1, 5, 8 | 1-13 |
| A | KR 10-2024-0105919 A (THE EAST CO., LTD.) 08 July 2024 (2024-07-08)<br>claims 1-14 and figures 1-6 | 1-13 |
| A | KR 10-2024-0093201 A (GOEUN CORP.) 24 June 2024 (2024-06-24)<br>claims 1-7 and figures 1-3 | 1-13 |
| A | KR 10-2024-0085061 A (EOM, Tae Yoon) 14 June 2024 (2024-06-14)<br>claims 1-4 and figures 1-3 | 1-13 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **21 July 2025** | **22 July 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/017529**

| Patent document cited in search report | | | Publication date (day/month/year) | Patent family member(s) | | | Publication date (day/month/year) |
|---|---|---|---|---|---|---|---|
| CN | 112148774 | A | 29 December 2020 | CN | 112148774 | B | 11 August 2023 |
| US | 2018-0025638 | A1 | 25 January 2018 | BR | 112013011412 | A2 | 02 August 2016 |
| | | | | CN | 103262136 | A | 21 August 2013 |
| | | | | CN | 103262136 | B | 12 October 2016 |
| | | | | CN | 103270780 | A | 28 August 2013 |
| | | | | CN | 103270780 | B | 12 January 2018 |
| | | | | CN | 103270781 | A | 28 August 2013 |
| | | | | CN | 103270781 | B | 28 September 2016 |
| | | | | CN | 106323313 | A | 11 January 2017 |
| | | | | CN | 106323313 | B | 25 October 2019 |
| | | | | CN | 106382943 | A | 08 February 2017 |
| | | | | CN | 106382943 | B | 18 June 2019 |
| | | | | CN | 106441327 | A | 22 February 2017 |
| | | | | CN | 106441327 | B | 29 November 2019 |
| | | | | EP | 2638533 | A1 | 18 September 2013 |
| | | | | EP | 2638533 | B1 | 10 January 2018 |
| | | | | EP | 2638710 | A2 | 18 September 2013 |
| | | | | EP | 2638710 | B1 | 21 February 2018 |
| | | | | EP | 2638711 | A1 | 18 September 2013 |
| | | | | EP | 2638711 | B1 | 23 May 2018 |
| | | | | EP | 3319345 | A1 | 09 May 2018 |
| | | | | EP | 3319345 | B1 | 12 June 2019 |
| | | | | JP | 2013-543973 | A | 09 December 2013 |
| | | | | JP | 2014-505914 | A | 06 March 2014 |
| | | | | JP | 2014-508276 | A | 03 April 2014 |
| | | | | JP | 2016-219035 | A | 22 December 2016 |
| | | | | JP | 2017-151114 | A | 31 August 2017 |
| | | | | JP | 5980221 | B2 | 31 August 2016 |
| | | | | JP | 6118256 | B2 | 19 April 2017 |
| | | | | JP | 6257327 | B2 | 10 January 2018 |
| | | | | JP | 6430568 | B2 | 28 November 2018 |
| | | | | JP | 6442446 | B2 | 19 December 2018 |
| | | | | KR | 10-1964782 | B1 | 02 April 2019 |
| | | | | KR | 10-2013-0127989 | A | 25 November 2013 |
| | | | | KR | 10-2018-0112094 | A | 11 October 2018 |
| | | | | US | 11355012 | B2 | 07 June 2022 |
| | | | | US | 2013-0304379 | A1 | 14 November 2013 |
| | | | | US | 2014-0002277 | A1 | 02 January 2014 |
| | | | | US | 2014-0018106 | A1 | 16 January 2014 |
| | | | | US | 2016-0005314 | A1 | 07 January 2016 |
| | | | | US | 9154909 | B2 | 06 October 2015 |
| | | | | US | 9792816 | B2 | 17 October 2017 |
| | | | | US | 9799219 | B2 | 24 October 2017 |
| | | | | US | 9830815 | B2 | 28 November 2017 |
| | | | | WO | 2012-062760 | A1 | 18 May 2012 |
| | | | | WO | 2012-062762 | A2 | 18 May 2012 |
| | | | | WO | 2012-062762 | A3 | 23 August 2012 |
| | | | | WO | 2012-062764 | A1 | 18 May 2012 |
| KR | 10-2024-0105919 | A | 08 July 2024 | KR | 10-2816821 | B1 | 05 June 2025 |
| KR | 10-2024-0093201 | A | 24 June 2024 | None | | | |

Form PCT/ISA/210 (patent family annex) (July 2022)

**INTERNATIONAL SEARCH REPORT**
Information on patent family members

International application No.

**PCT/KR2024/017529**

| Patent document cited in search report | Publication date (day/month/year) | Patent family member(s) | Publication date (day/month/year) |
|---|---|---|---|
| KR 10-2024-0085061 A | 14 June 2024 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 2063358